# EUROPEAN PATENT APPLICATION

(11) **EP 4 472 360 A1**
(43) Date of publication of application: **04.12.2024**
(21) Application number: 23747208.9
(22) Date of filing: 11.01.2023
(51) Int. Cl.: H05K 1/02, H05K 1/09, G06K 19/07

(54) **SMART IC SUBSTRATE, SMART IC MODULE, AND IC CARD COMPRISING SAME**

(30) Priority: 26.01.2022 KR 20220011152
(71) Applicant: LG INNOTEK CO., LTD., Seoul 07796 (KR)
(72) Inventor: HYEON, Jeong Min, Seoul 07796 (KR); KIM, Seung Joon, Seoul 07796 (KR); OH, Jung Hun, Seoul 07796 (KR)
(74) Representative: DREISS Patentanwälte PartG mbB
(86) International application number: PCT/KR2023/000521
(87) International publication number: WO 2023/146165

(57) **Abstract**

A smart IC substrate according to an embodiment includes a substrate including a first surface and a second surface opposite the first surface; and a circuit pattern disposed on at least one of the first surface and the second surface, wherein the circuit pattern includes a first metal layer and a second metal layer on the first metal layer, and wherein the second metal layer has an L* value of 83 to 87, an a* value of 12.0 to 13.5, and a b* value of 15 to 20 in a CIE L*a*b* color space.

## Description

### [Technical Field]

An embodiment re An embodiment relates to a smart IC substrate, a smart IC module, and an IC card comprising the same.

### [Background Art]

An IC card is formed by combining a smart IC module and a card module.

The smart IC module is a substrate on which an IC that stores personal security information required for electronic residence cards, credit card USIMs, etc. is mounted. The smart IC can transmit the information to a reader in a form of an electrical signal.

The smart IC module may be classified into a single type and a dual type according to a structure of the substrate. In addition, the smart IC module may be classified into contact, contactless, hybrid, and combi cards according to a form of a card used.

The contact smart IC module uses a method of transmitting and receiving information by physical contact. In addition, the contactless smart IC module uses a method of transmitting and receiving information without physical contact. In addition, the combi smart IC module and the hybrid smart IC module use a method that includes both the physical contact function and the NFC function without physical contact.

Accordingly, the smart IC module may include a contact surface and a bonding surface. A chip is disposed on the bonding surface. In addition, the contact surface may directly or indirectly contact other external devices.

Recently, in order to improve the design of the IC card, a color of the circuit pattern on the contact surface has been diversified.

However, when the color of the circuit pattern is formed, characteristics of the circuit pattern may be reduced by changes in physical characteristics of an uppermost layer of the circuit pattern.

In addition, a process of manufacturing the smart IC module may be increased.

Therefore, a new structure of smart IC substrate, smart IC module, and IC card that can solve the above problems are required.

### [Disclosure]

### [Technical Problem]

An embodiment is to provide a smart IC module capable of improving user visibility by forming a contact surface in a color having a set range of color coordinates.

### [Technical Solution]

A smart IC substrate according to an embodiment includes a substrate including a first surface and a second surface opposite the first surface; and a circuit pattern disposed on at least one of the first surface and the second surface, wherein the circuit pattern includes a first metal layer and a second metal layer on the first metal layer, and wherein the second metal layer has an L* value of 83 to 87, an a* value of 12.0 to 13.5, and a b* value of 15 to 20 in a CIE L*a*b* color space.

### [Advantageous Effects]

A contact surface and a bonding surface of the smart IC substrate according to the embodiment may be formed in various colors.

The smart IC substrate according to an embodiment may have a color having a color coordinate of a set range on the contact surface.

Specifically, a metal layer disposed at an outermost side of the circuit pattern includes a copper-gold alloy formed in wt% in a set range. Thereby, the contact surface may have a rose gold color.

The contact surface is a surface that is recognized by an external user. Therefore, it is possible to increase aesthetics while preventing corrosion of the pattern through the contact surface.

In addition, the contact surface and the bonding surface of the smart IC substrate according to the embodiment may have different colors. The bonding surface is a surface that is not visible to the external user.

In detail, the contact surface may have a color capable of improving the user's aesthetics by a metal layer having a color coordinate in a set range. In addition, the bonding surface may be formed in a single layer or multiple layers to protect circuit patterns.

Accordingly, the circuit pattern of the contact surface and the bonding surface is formed of different materials. Accordingly, the metal layer may be formed by a process suitable for each surface. Accordingly, the process efficiency may be improved.

### [Description of Drawings]

FIG. 1 is a top view of a first surface of a smart IC substrate according to an embodiment.
FIGS. 2 and 3 are top views of a second surface of a smart IC substrate according to an embodiment.
FIGS. 4 and 5 are top views of a bonding surface of a smart IC module according to an embodiment.
FIG. 6 is a cross-sectional view taken along a region A-A' in FIG. 4.
FIGS. 7 and 8 are cross-sectional views taken along a region A-A' in FIG. 5.
FIGS. 9 is a view for explaining the color coordinates of a circuit pattern of a smart IC substrate according to an embodiment.
FIGS. 10 is a top view of an IC card according to an embodiment.

### [Modes of the Invention]

Hereinafter, embodiments of the present disclosure will be described in detail with reference to the accompanying drawings. However, the spirit and scope of the present disclosure is not limited to a part of the embodiments described, and may be implemented in various other forms, and within the spirit and scope of the present disclosure, one or more of the elements of the embodiments may be selectively combined and replaced.

In addition, unless expressly otherwise defined and described, the terms used in the embodiments of the present disclosure (including technical and scientific terms) may be construed the same meaning as commonly understood by one of ordinary skill in the art to which this invention belongs, and the terms such as those defined in commonly used dictionaries may be interpreted as having a meaning that is consistent with their meaning in the context of the relevant art.

In addition, the terms used in the embodiments of the present disclosure are for describing the embodiments and are not intended to limit the present disclosure. In this specification, the singular forms may also include the plural forms unless specifically stated in the phrase, and may include at least one of all combinations that may be combined in A, B, and C when described in "at least one (or more) of A (and), B, and C".

Further, in describing the elements of the embodiments of the present disclosure, the terms such as first, second, A, B, (a), and (b) may be used. These terms are only used to distinguish the elements from other elements, and the terms are not limited to the essence, order, or order of the elements.

In addition, when an element is described as being "connected", "coupled", or "connected" to another element, it may include not only when the element is directly "connected" to, "coupled" to, or "connected" to other elements, but also when the element is "connected", "coupled", or "connected" by another element between the element and other elements.

Further, when described as being formed or disposed "on (over)" or "under (below)" of each element, the "on (over)" or "under (below)" may include not only when two elements are directly connected to each other, but also when one or more other elements are formed or disposed between two elements.

Furthermore, when expressed as "on (over)" or "under (below)", it may include not only the upper direction but also the lower direction based on one element.

Hereinafter, a smart IC substrate, a smart IC module, and an IC card including the same according to an embodiment will be described with reference to the drawings.

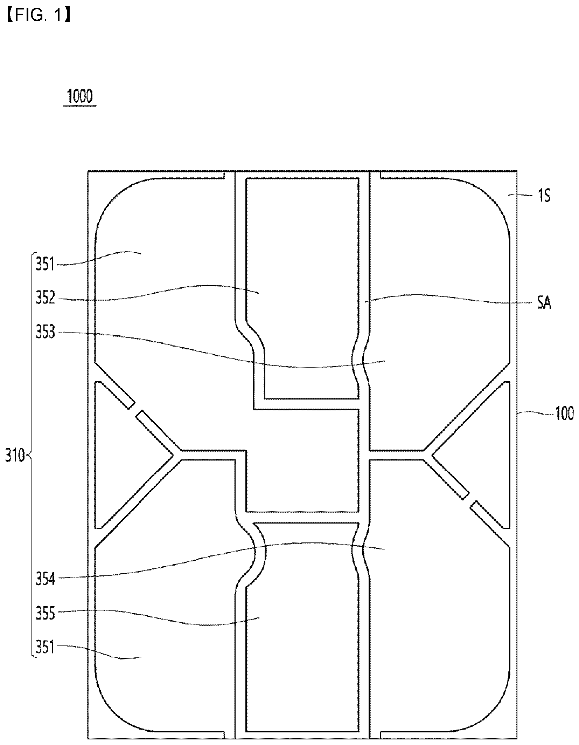

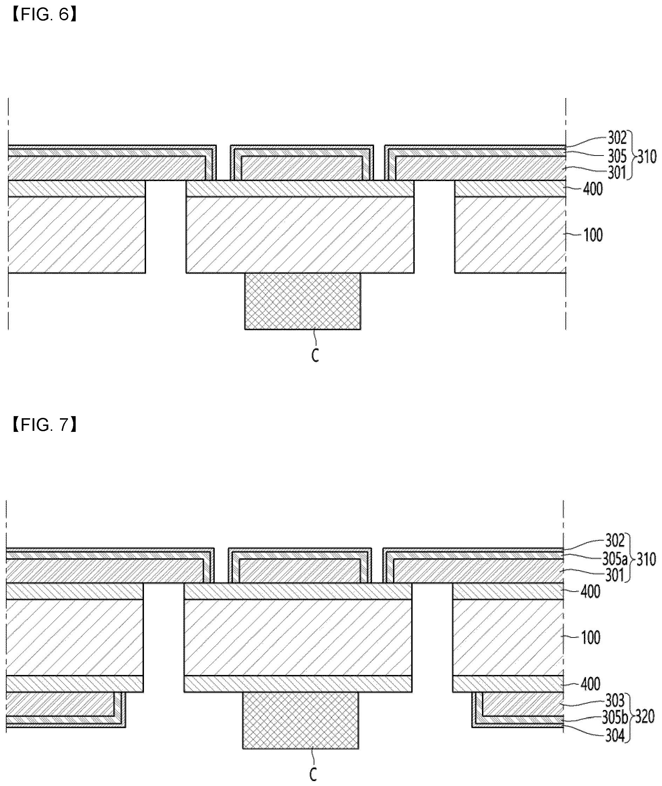

FIGS. 1 to 8 are views illustrating top views of one surface and the other surface of a smart IC substrate according to an embodiment, and a cross-sectional view of a smart IC module.

Referring to FIGS. 1 to 3, a smart IC substrate 1000 includes one surface and the other surface opposite to the one surface. A chip is mounted on the smart IC substrate 1000. Accordingly, a smart IC module may be formed. The one surface may be defined as a contact surface of the smart IC substrate 1000. Also, the other surface may be defined as a bonding surface of the smart IC substrate 1200.

The one surface is a surface that can recognize information of the smart IC module by direct or indirect contact with the IC card. In addition, a chip is mounted on the other surface. In addition, the other surface is adhered to a main body of the IC card.

The smart IC substrate 1000 includes a substrate 100 and a plurality of circuit patterns.

The substrate 100 may include a resin material. The substrate 100 includes a first surface 1S and a second surface 2S opposite the first surface 1S. The first surface 1S is defined as a surface corresponding to the one surface. That is, the first surface 1S is defined as a surface corresponding to the contact surface. Also, the second surface 2S is defined as a surface corresponding to the bonding surface.

The substrate 100 may include a prepreg including a glass fiber. In detail, the substrate 100 includes an epoxy resin, a glass fiber, and a silicon-based filler. The glass fiber and the silicon-based filler are dispersed in the epoxy resin.

The substrate 100 may be rigid or flexible. For example, the substrate 100 may include a glass or a plastic. In detail, the substrate 100 may include a chemically reinforced glass or semi-reinforced glass such as soda lime glass or aluminosilicate glass. Alternatively, the substrate 100 may include a reinforced plastic or a flexible plastic such as polyimide (PI), polyethylene terephthalate (PET), propylene glycol (PPG) or polycarbonate (PC). Alternatively, the substrate 100 may include sapphire.

Also, the substrate 100 may include a photo isotropic film. For example, the substrate 100 may include cyclic olefin copolymer (COC), cyclic olefin polymer (COP), photo isotropic polycarbonate (PC), or photo isotropic polymethyl methacrylate (PMMA).

In addition, the substrate 100 may be partially bent having a curved surface. That is, the substrate 100 may partially have a plane and may be partially bent having a curved surface. In detail, an end of the substrate 100 may be bent while having a curved surface.

Furthermore, the substrate 100 may be a flexible substrate having flexible characteristics. Furthermore, the substrate 100 may be a curved or bent substrate.

An adhesive layer 400 is disposed on at least one of the first surface 1S and the second surface 2S. The adhesive layer 400 may be disposed on both the first surface 1S and the second surface 2S. Specifically, the adhesive layer 400 may be entirely disposed on both the first surface 1S and the second surface 2S except for a region in which a via is formed.

The adhesive layer 400 may include a resin material. For example, the adhesive layer 400 may include at least one of an epoxy resin, an acrylic resin, and a polyimide resin. Additionally, additives such as natural rubber, plasticizer, hardener, or phosphorus-based flame retardant may be added to the adhesive layer 400. Accordingly, the adhesive layer 400 may have flexibility.

The adhesive layer 400 may have a thickness in a set range. For example, a thickness of the adhesive layer 400 may be 15 µm to 30 µm. When the thickness of the adhesive layer 400 is less than 15 µm, an adhesive force of the adhesive layer is reduced. Accordingly, the circuit pattern may be separated. Also, when the thickness of the adhesive layer 400 is more than 30 µm, a thickness of the smart IC substrate may be increased by the adhesive layer.

A circuit pattern is disposed on the substrate 100. In detail, a circuit pattern may be disposed on at least one of the first surface 1S and the second surface 2S.

For example, referring to FIGS. 1, 2, 4, and 6, a circuit pattern may be disposed only on one of the first surface 1S and the second surface 2S. Specifically, a first circuit pattern 310 may be disposed on the adhesive layer 400 on the first surface 1S, and also, the adhesive layer 400 and the circuit pattern may not be disposed on the second surface 2S.

Alternatively, referring to FIGS. 1, 3, 5 and 7, a circuit pattern may be disposed on the first surface 1S and the second surface 2S, respectively. Specifically, a first circuit pattern 310 on the adhesive layer 400 may be disposed on the first surface 1S. Also, a second circuit pattern 320 on the adhesive layer 400 may be disposed on the second surface 2S.

The first circuit pattern 310 may include a plurality of circuit patterns.

For example, the first circuit pattern 310 may include a first-first circuit pattern 351, a first-second circuit pattern 352, a first-third circuit pattern 353, a first-fourth circuit pattern 354, a first-fifth circuit pattern 355, and a first-sixth circuit pattern 356.

In FIG. 1, six circuit patterns are illustrated, but embodiments are not limited thereto.

The plurality of circuit patterns 351, 352, 353, 354, 355, and 356 are spaced apart from each other.

Specifically, space regions SA in which a circuit pattern is not disposed are formed between the plurality of circuit patterns 351, 352, 353, 354, 355, and 356. The plurality of circuit patterns 351, 352, 353, 354, 355, and 356 may be spaced apart from each other by the space region SA. That is, the space region SA is an interval between the plurality of circuit patterns 351, 352, 353, 354, 355, and 356.

The space region SA may have a predetermined size. For example, the space region SA may be in a range of 100 µm to 250 µm.

Accordingly, the plurality of circuit patterns 351, 352, 353, 354, 355, and 356 are not electrically connected to each other on the first surface 1S.

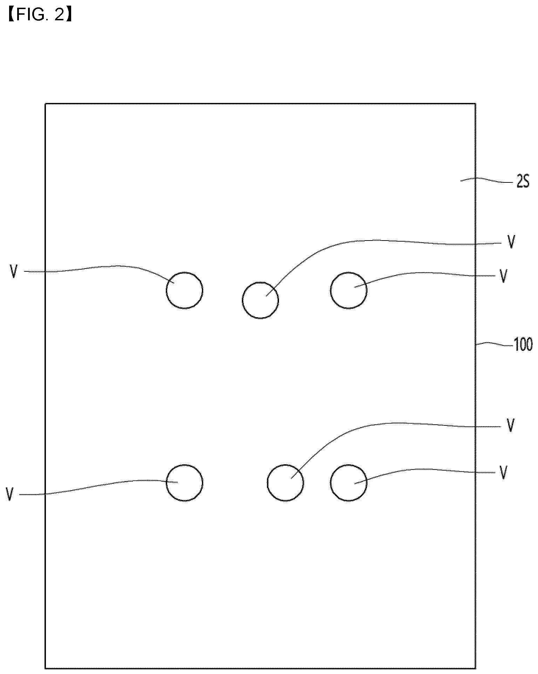

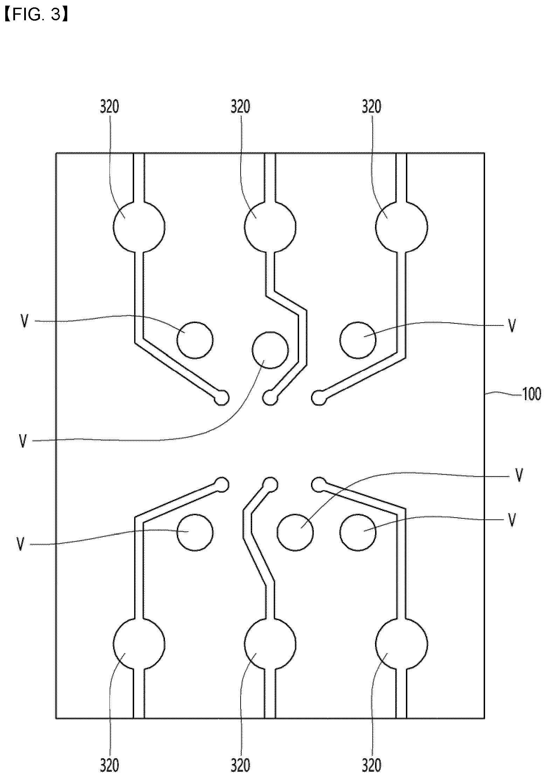

Referring to FIGS. 2 and 3, the substrate 100 includes a plurality of vias V. Each of the plurality of vias V overlaps any one of the plurality of circuit patterns 351, 352, 353, 354, 355, and 356.

The chip C disposed on the second surface 2S and the first circuit pattern 310 disposed on the first surface 1S are electrically connected by the via V.

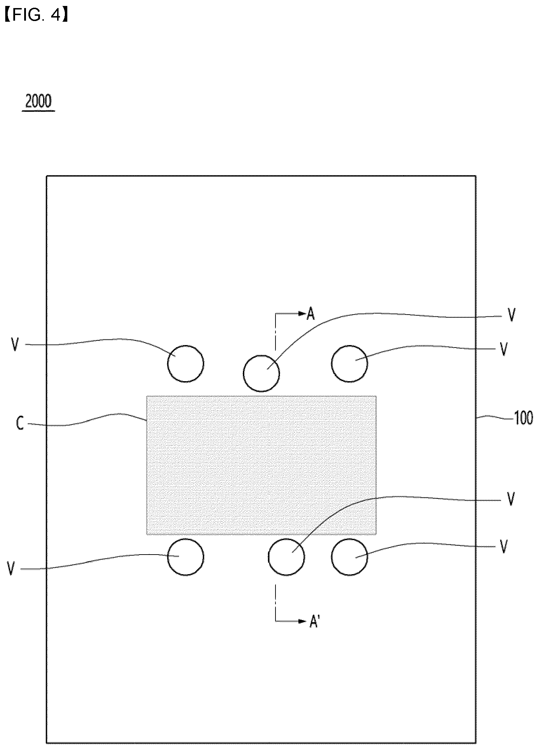

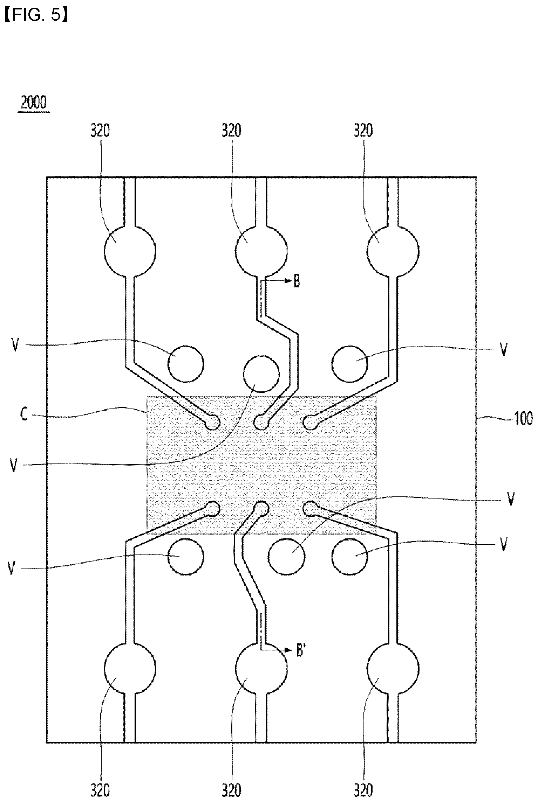

Accordingly, the smart IC module 2000 may be formed as shown in FIGS. 4 and 5.

At least one circuit pattern of the first circuit pattern 310 and the second circuit pattern 320 may include a first metal layer 301 and a second metal layer 302. Specifically, the first metal layer 301 is disposed on the adhesive layer 400. Also, the second metal layer 302 is disposed on the first metal layer 301.

The first metal layer 301 may include a metal material. Specifically, the first metal layer 301 may include a metal material having high electrical conductivity. For example, the first metal layer 301 may include at least one of gold (Au), silver (Ag), platinum (Pt), titanium (Ti), tin (Sn), copper (Cu), and zinc (Zn). Preferably, the first metal layer 301 may include copper (Cu).

The first metal layer 301 may have a thickness within a set range. Specifically, the thickness of the first metal layer 301 may be 35 µm to 70 µm. When the thickness of the first metal layer 301 is less than 35 µm, conductivity of the first metal layer 301 is reduced. Accordingly, electrical characteristics of the smart IC substrate may be reduced. Also, when the thickness of the first metal layer 301 is more than 70 µm, the thickness of the first metal layer 301 is increased. Accordingly, the thickness of the smart IC substrate may be increased.

The second metal layer 302 is disposed on the first metal layer 301. The second metal layer 302 may be disposed to surround the first metal layer 301. The second metal layer 302 may be disposed on all surfaces of the first metal layer 301.

The second metal layer 302 may protect the first metal layer 301. That is, the second metal layer 302 may prevent corrosion of the first metal layer 301. That is, the second metal layer 302 may be a protective layer of the circuit pattern.

Also, the circuit pattern may have various colors by the second metal layer 302. The second metal layer 302 is disposed at an outermost side of the circuit pattern. Accordingly, a color of the circuit pattern is formed as a color of the second metal layer 302.

Referring to FIGS. 1, 2, 4, and 6, the first circuit pattern 310 may further include an intermediate layer 305.

The intermediate layer 305 is disposed between the first metal layer 301 and the second metal layer 302. The intermediate layer 305 may be disposed to surround the first metal layer 301. Specifically, the intermediate layer 305 may be disposed on an upper surface and a side surface of the first metal layer 301. Also, the second metal layer 302 may be disposed to surround the intermediate layer 305.

The adhesion between the first metal layer 301 and the second metal layer 302 may be improved by the intermediate layer 302. That is, the intermediate layer 305 may be an adhesion enhancement layer.

The intermediate layer 305 may have a color different from those of the first metal layer 301 and the second metal layer 302. Also, the intermediate layer 305 may include a material different from those of the first metal layer 301 and the second metal layer 302.

For example, the intermediate layer 305 may include a metal. For example, the intermediate layer 305 may include nickel (Ni).

The first circuit pattern 310 may include a copper alloy. Specifically, the second metal layer 302 may include a copper alloy. Specifically, the second metal layer 302 may include a copper-gold (Cu-Au) alloy.

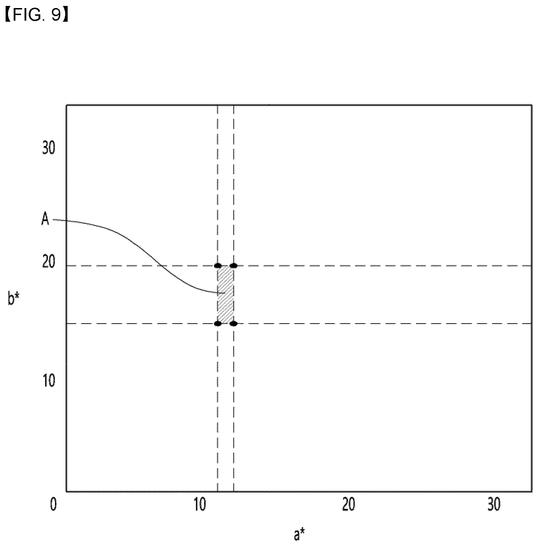

The second metal layer 302 may include a copper-gold (Cu-Au) alloy having color coordinates in a set range. Referring to FIG. 9, the second metal layer 302 may include a copper-gold (Cu-Au) alloy having an L* value of 83 to 87, an a* value of 12.0 to 13.5, and a b* value of 15 to 20 in a CIE L*a*b* color space.

That is, the second metal layer 302 may have a color of A region of FIG. 9. Specifically, the second metal layer 302 has a similar redness (a*value) as compared to pure copper. Also, the second metal layer 302 has a similar or greater yellowness (b*value) as compared to pure copper. Accordingly, the second metal layer 302 may have a rose gold color in which a rose color and a gold color are mixed.

When a total wt% of the copper-gold (Cu-Au) alloy is 100 wt%, the second metal layer 302 may include a copper-gold (Cu-Au) alloy containing 30 wt% or more of copper. In detail, the second metal layer 302 may include a copper-gold (Cu-Au) alloy containing 35 wt% or more of copper. In more detail, the second metal layer 302 may include a copper-gold (Cu-Au) alloy containing 40 wt% or more of copper. In more detail, the second metal layer 302 may include a copper-gold (Cu-Au) alloy containing 50 wt% or more of copper.

For example, the second metal layer 302 may include a copper-gold (Cu-Au) alloy containing 30 wt% to 90 wt% of copper. In detail, the second metal layer 302 may include a copper-gold (Cu-Au) alloy containing 30 wt% to 80 wt% of copper. In more detail, the second metal layer 302 may include a copper-gold (Cu-Au) alloy containing 35 wt% to 70 wt% of copper. In more detail, the second metal layer 302 may include a copper-gold (Cu-Au) alloy containing 35 wt% to 60 wt% of copper.

Meanwhile, the second metal layer 302 may contain a small amount of impurities such as silver, nickel, aluminum, or chromium in addition to copper and gold.

When the copper of the second metal layer 302 is contained in an amount of less than 30 wt%, the redness (a*value) of the copper-gold (Cu-Au) alloy is reduced. Accordingly, the second metal layer 302 cannot have a desired color in a color coordinate range. Furthermore, when the copper of the second metal layer 302 is contained in an amount greater than 90 wt%, the yellowness (b*value) of the copper-gold (Cu-Au) alloy is reduced. Accordingly, the second metal layer 302 cannot have a desired color in a color coordinate range. Furthermore, physical properties of the second metal layer 302 are changed. Accordingly, the first metal layer cannot be effectively protected by the second metal layer.

Also, when the copper of the second metal layer 302 exceeds 60 wt%, the second metal layer 302 may have a color within the color coordinate range under some environmental conditions. However, red discoloration may occur under following reliability test conditions. Also, a resistance of the second metal layer may exceed 0.5Ω.

Test conditions: 100 ppb of hydrogen sulfide (H₂S), 500 ppb of sulfur dioxide (SO₂), 5°C, 75% R.H. 240Hr

The second metal layer 302 and the intermediate layer 305 may be disposed to have different thicknesses. Specifically, a thickness of the intermediate layer 305 may be greater than a thickness of the second metal layer 302. For example, the thickness of the second metal layer 302 may be 0.3% to 15% of the thickness of the intermediate layer 305.

For example, the thickness of the intermediate layer 305 may be 0.5 µm or more. Specifically, the thickness of the intermediate layer 305 may be 1 µm to 7 µm. Specifically, the thickness of the intermediate layer 305 may be 1 µm to 5 µm.

Also, the thickness of the second metal layer 302 may be 0.01 µm or more. Specifically, the thickness of the second metal layer 302 may be 0.01 µm to 0.3 µm. Specifically, the thickness of the second metal layer 302 may be 0.03 µm to 0.1 µm.

When the thickness of the second metal layer 302 is less than 0.3% of the thickness of the intermediate layer 305, the thickness of the second metal layer 302 becomes too small. Accordingly, the process efficiency may be reduced. Also, the color of the second metal layer 302 may not be sufficiently formed.

Also, when the thickness of the second metal layer 302 exceeds 15% of the thickness of the intermediate layer 305, the thickness of the second metal layer 302 becomes thicker. Accordingly, the thickness of the circuit pattern may be increased. Therefore, a thickness of the IC card to which the smart IC substrate is applied may be increased.

Referring to FIGS. 1, 3, 5, 7, and 8, the smart IC substrate may include the first circuit pattern 310 and the second circuit pattern 320.

The first circuit pattern 310 may include a first metal layer 301 and a second metal layer 302 disposed on the first metal layer 301. Also, a first intermediate layer 305a may be disposed between the first metal layer 301 and the second metal layer 302.

The second circuit pattern 320 may include a third metal layer 303 and a fourth metal layer 304 under the third metal layer 303. Also, a second intermediate layer 305b may be disposed between the third metal layer 303 and the fourth metal layer 304.

The first metal layer 301 and the third metal layer 30 may include the same or similar material. Alternatively, the first metal layer 301 and the third metal layer 303 may include different materials.

Furthermore, the first metal layer 301 and the third metal layer 303 may be formed to have the same or similar thickness. Alternatively, the first metal layer 301 and the third metal layer 303 may be formed to have different thicknesses.

The first intermediate layer 305a and the second intermediate layer 305b may include the same or similar material. For example, the first intermediate layer 305a and the second intermediate layer 305b may include nickel (Ni).

Also, the second metal layer 302 and the fourth metal layer 304 may include the same or different materials.

For example, the second metal layer 302 and the fourth metal layer 304 may include the same material.

In detail, the second metal layer 302 and the fourth metal layer 304 may include an alloy having the color coordinate range described above. In detail, the second metal layer 302 and the fourth metal layer 304 may include a copper-gold (Cu-Au) alloy having an L* value of 83 to 87, an a* value of 12.0 to 13.5, and a b* value of 15 to 20 in a CIE L*a*b* color space.

That is, both the second metal layer 302 and the fourth metal layer 304 may include a copper-gold (Cu-Au) alloy. Also, the second metal layer 302 and the fourth metal layer 304 may include a copper-gold (Cu-Au) alloy having the color coordinate range.

Alternatively, the second metal layer 302 and the fourth metal layer 304 may include a different material.

Specifically, the second metal layer 302 may include the alloy having the color coordinate range described above. Specifically, the second metal layer 302 may include a copper-gold (Cu-Au) alloy having an L* value of 83 to 87, an a* value of 12.0 to 13.5, and a b* value of 15 to 20 in a CIE L*a*b* color space.

Also, the fourth metal layer 304 may include gold (Au) or palladium (Pd). For example, a gold (Au) layer may be disposed under the second intermediate layer 305b after the second intermediate layer 305b is formed under the third metal layer 303. Alternatively, a palladium layer may be disposed under the second intermediate layer 305b after the second intermediate layer 305b is formed under the third metal layer 301.

When the second intermediate layer 305b includes nickel, a nickel-gold alloy layer may be formed between the second intermediate layer 305b and the gold layer. Also, a nickel-palladium alloy layer may be formed between the second intermediate layer 305b and the palladium layer.

Accordingly, the first circuit pattern 310 and the second circuit pattern 320 may be formed in different colors. That is, the first circuit pattern 310 and the second circuit pattern 320 may be formed in colors having different coordinates in a CIE L*a*b* color space.

The fourth metal layer 304 is a layer disposed on a bonding surface of a smart IC substrate. Accordingly, the fourth metal layer 304 is not visually recognized to users from an outside. Accordingly, the fourth metal layer 304 may be formed of a material for protecting the third metal layer 303. Accordingly, process costs may be reduced and process efficiency may be improved.

That is, an alloy layer having a color coordinate range set only in the second metal layer 302 of the contact surface may be formed. Also, a layer including a single material may be formed on the fourth metal layer 304 of the bonding surface. Therefore, the second metal layer and the fourth metal layer may be formed to suit the use of each surface of the smart IC substrate. Therefore, it is possible to have improved process efficiency.

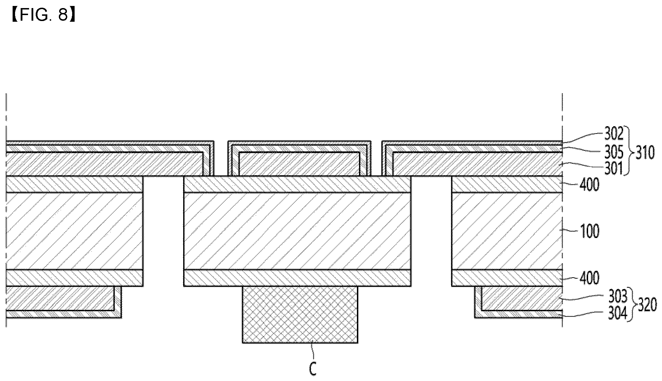

Referring to FIG. 8, the first circuit pattern 310 and the second circuit pattern 320 may include different layers.

The first circuit pattern 310 may include a first metal layer 301 and a second metal layer 302. Also, an intermediate layer 305 may be disposed between the first metal layer 301 and the second metal layer 302.

The second circuit pattern 320 may include a third metal layer 303 and a fourth metal layer 304. The fourth metal layer 304 may be directly disposed under the third metal layer 303. Specifically, the fourth metal layer 304 may be in contact with the third metal layer 303. That is, the fourth metal layer 304 may be disposed to surround the third metal layer 303. That is, the fourth metal layer 304 may be disposed on a lower surface and a side surface of the third metal layer 303.

The third metal layer 303 and the fourth metal layer 304 may include different materials. Also, the third metal layer 303 and the fourth metal layer 304 may have different thicknesses.

That is, the second circuit pattern 320 does not include the intermediate layer.

The second metal layer 302 may include a material different from at least one of the third metal layer 303 and the fourth metal layer 304.

For example, the second metal layer 302 may include the alloy having the color coordinate range described above. Specifically, the second metal layer 302 may include a copper-gold (Cu-Au) alloy having an L* value of 83 to 87, an a* value of 12.0 to 13.5, and a b* value of 15 to 20 in a CIE L*a*b* color space.

The fourth metal layer 304 may include a binary alloy. In detail, the fourth metal layer 304 may include a nickel-gold (Ni-Au) alloy or a nickel-palladium (Ni-Pd) alloy.

Accordingly, the first circuit pattern 310 and the second circuit pattern 320 may be formed in different colors.

The fourth metal layer 304 is a layer disposed on a bonding surface of a smart IC substrate. Accordingly, the fourth metal layer 304 may include a metal layer formed in a single process using a material for protecting the first metal layer 301. Therefore, process costs can be reduced and process efficiency can be improved.

That is, it is formed as a multilayer including an alloy layer having a color coordinate range set only in the second metal layer 302 of the contact surface. Also, the fourth metal layer 304 of the bonding surface is formed as a single layer having an alloy material. Accordingly, the metal layer may be formed to suit the use of each surface of the smart IC substrate. Therefore, it is possible to have improved process efficiency during manufacturing.

A contact surface and a bonding surface of the smart IC substrate according to the embodiment may be formed in various colors.

The smart IC substrate according to an embodiment may have a color having a color coordinate of a set range on the contact surface.

Specifically, a metal layer disposed at an outermost side of the circuit pattern includes a copper-gold alloy formed in wt% in a set range. Thereby, the contact surface may have a rose gold color.

The contact surface is a surface that is recognized by an external user. Therefore, it is possible to increase aesthetics while preventing corrosion of the pattern through the contact surface.

In addition, the contact surface and the bonding surface of the smart IC substrate according to the embodiment may have different colors. The bonding surface is a surface that is not visible to the external user.

In detail, the contact surface may have a color capable of improving the user's aesthetics by a metal layer having a color coordinate in a set range. In addition, the bonding surface may be formed in a single layer or multiple layers to protect circuit patterns.

Accordingly, the circuit pattern of the contact surface and the bonding surface is formed of different materials. Accordingly, the metal layer may be formed by a process suitable for each surface. Accordingly, the process efficiency may be improved.

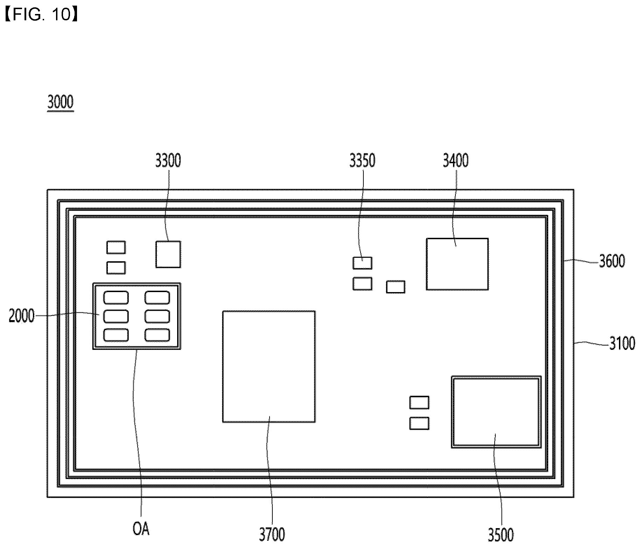

FIG. 10 is a view illustrating a top view of an IC card to which a smart IC substrate according to an embodiment is applied.

Referring to FIG. 10, a IC card 3000 may include a card body 3100 and a smart IC substrate module 2000, a chip 3300, a micro-control unit (MCU) 3400, a connection circuit pattern 3350 electrically connecting the chip 3300 to the micro-control unit 3400, a fingerprint sensor 3500, an antenna 3600, and a battery 3700.

The smart IC substrate module 2000 may be accommodated in the card body 3100. Specifically, the card body 3100 includes an opening OA. The smart IC substrate module 2000 may be inserted into and attached to the opening OA.

Accordingly, the contact surface of the smart IC substrate module 2000 may be exposed to an outside of the IC card.

The IC card may include a fingerprint sensor 3500. The fingerprint sensor 3500 recognizes a user's fingerprint. It may also match the fingerprint information stored in the chip 3300.

That is, the chip 3300 stores fingerprint information of a predetermined user. The fingerprint recognized through the fingerprint sensor 3500 may match the fingerprint information stored in the chip 3300.

For example, when a user's finger contacts the fingerprint sensor 3500, power is supplied from the battery 3700 to the micro-control unit 3400. Subsequently, the fingerprint sensor 3500 supplied with power by the micro-control unit 3400 may be driven.

Subsequently, the micro-control unit 3300 receives the recognized fingerprint information through the fingerprint sensor 3500. Subsequently, a process of authenticating the recognized fingerprint information may proceed.

When the recognized fingerprint information matches the fingerprint information stored in the chip 3300, the smart IC substrate module 2000 is activated. Accordingly, the function of the IC card is also activated.

When the recognized fingerprint information does not match the fingerprint information stored in the chip 3300, the smart IC substrate 2000 is deactivated. Accordingly, the function of the IC card is also deactivated.

However, the embodiment is not limited thereto, and the IC card may not include the fingerprint sensor 3500. That is, the IC card may activate the function of the IC card without separate fingerprint authentication.

Also, the IC card may include an antenna 3600. Accordingly, the IC card may operate as a contactless card. That is, information can be transmitted and received wirelessly with the server through the antenna even without contact with the card reader.

However, embodiments are not limited thereto, and the IC card may not include the antenna 3600. That is, the IC card may operate as a contact type card. That is, the IC card is inserted into the reader and can transmit and receive information to the server due to contact with the circuit board.

The characteristics, structures and effects described in the embodiments above are included in at least one embodiment but are not limited to one embodiment. Furthermore, the characteristics, structures, and effects and the like illustrated in each of the embodiments may be combined or modified even with respect to other embodiments by those of ordinary skill in the art to which the embodiments pertain. Thus, it should be construed that contents related to such a combination and such a modification are included in the scope of the embodiment.

The above description has been focused on the embodiment, but it is merely illustrative and does not limit the embodiment. A person skilled in the art to which the embodiment pertains may appreciate that various modifications and applications not illustrated above are possible without departing from the essential features of the embodiment. For example, each component particularly represented in the embodiment may be modified and implemented. In addition, it should be construed that differences related to such changes and applications are included in the scope of the embodiment defined in the appended claims.

## Claims

1. A smart IC substrate comprising:
a substrate including a first surface and a second surface opposite the first surface; and
a circuit pattern disposed on at least one of the first surface and the second surface,
wherein the circuit pattern includes a first metal layer and a second metal layer on the first metal layer, and
wherein the second metal layer has an L* value of 83 to 87, an a* value of 12.0 to 13.5, and a b* value of 15 to 20 in a CIE L*a*b* color space.

2. The smart IC substrate of claim 1, wherein the second metal layer includes a copper-gold (Cu-Au) alloy, and
wherein the copper-gold alloy contains 30 wt% to 60 wt% of copper.

3. The smart IC substrate of claim 1, wherein the second metal layer has a rose gold color.

4. The smart IC substrate of claim 1, further comprising:
an intermediate layer disposed between the first metal layer and the second metal layer.

5. The smart IC substrate of claim 4, wherein a thickness of the second metal layer and a thickness of the intermediate layer are different from each other.

6. The smart IC substrate of claim 4, wherein a thickness of the intermediate layer is greater than that of the second metal layer.

7. The smart IC substrate of claim 4, wherein a thickness of the second metal layer is 0.3% to 15% of a thickness of the intermediate layer.

8. The smart IC substrate of claim 4, wherein a thickness of the intermediate layer is 1 µm to 7 µm, and
wherein a thickness of the second metal layer is 0.01 µm to 0.3 µm.

9. The smart IC substrate of claim 1, wherein the circuit pattern includes:
a first circuit pattern disposed on the first surface; and
a second circuit pattern disposed on the second surface,
wherein the first circuit pattern includes a first metal layer and a second metal layer on the first metal layer,
wherein the second circuit pattern includes a third metal layer and a fourth metal layer under the third metal layer, and
wherein the first circuit pattern and the second circuit pattern are formed in different colors.

10. The smart IC substrate of claim 9, wherein the second metal layer and the fourth metal layer includes different materials.

11. The smart IC substrate of claim 9, wherein the second metal layer includes a copper-gold (Cu-Au) alloy including 30 to 60 wt% of copper, and,
wherein the fourth metal layer includes a gold or a palladium.

12. The smart IC substrate of claim 1, wherein the circuit pattern includes:
a first circuit pattern disposed on the first surface; and
a second circuit pattern disposed on the second surface,
wherein the first circuit pattern includes a first metal layer and a second metal layer on the first metal layer,
wherein the second circuit pattern includes a third metal layer and a fourth metal layer under the third metal layer, and
wherein the first circuit pattern and the second circuit pattern are formed in different materials.

13. The smart IC substrate of claim 12, further comprising:
a first intermediate layer disposed between the first metal layer and the second metal layer, and
a second intermediate layer disposed between the third metal layer and the fourth metal layer,
wherein the first intermediate layer includes a nickel, and
wherein the second intermediate layer includes a nickel-gold (Ni-Au) alloy or a nickel-palladium (Ni-Pd) alloy.

14. The smart IC substrate of claim 12, wherein the second metal layer includes a copper-gold (Cu-Au) alloy containing 30 to 60 wt% of copper.

15. A smart IC module comprising:
the smart IC substrate of any of claims 1 to 14; and
a chip disposed on the second surface.

16. The smart IC module of claim 15, wherein the circuit pattern is disposed on the first surface.

17. The smart IC module of claim 15, wherein the first surface is a contact surface, and
wherein the second surface is a bonding surface.

18. A IC card comprising:
a card body having an opening; and
the smart IC module of claim 15 inserted and attached in the opening.

19. The IC card of claim 18, wherein the first surface is a contact surface, and
wherein the second surface is a bonding surface.

20. The IC card of claim 19, wherein the first surface is exposed to an outside of the IC card.
